(19) 

**Europäisches Patentamt**
**European Patent Office**
**Office européen des brevets**

(11) **EP 4 703 745 A1**

(12) **EUROPEAN PATENT APPLICATION**

(43) Date of publication:
**04.03.2026 Bulletin 2026/10**

(21) Application number: **25192791.9**

(22) Date of filing: **30.07.2025**

(51) International Patent Classification (IPC):
**G01R 31/28** (2006.01) **G05B 13/00** (2006.01)

(52) Cooperative Patent Classification (CPC):
**G01R 31/2837**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **30.08.2024 JP 2024148317**

(71) Applicant: **OMRON Corporation
Kyoto-shi, Kyoto 600-8530 (JP)**

(72) Inventors:
• **HARADA, Hiroyuki
600-8530 Kyoto (JP)**
• **EGI, Mamoru
600-8530 Kyoto (JP)**

(74) Representative: **Isarpatent
Patent- und Rechtsanwälte
Barth Hassa Peckmann & Partner mbB
Friedrichstraße 31
80801 München (DE)**

(54) **MEASUREMENT ASSISTANCE DEVICE**

(57) A present measurement assistance device is a measurement assistance device that inputs a measurement signal used for a frequency response analysis of a servo system to the servo system, the measurement assistance device including a generation unit configured to generate a first signal determined to eliminate a shift between a first position of a load of the servo system at a start of an excitation with respect to the servo system of a speed command signal that changes with time to include a large number of frequency components and a second position of the load at an end of the excitation of the speed command signal, a synthesizing unit configured to generate a synthesized signal in which the first signal is superimposed on the speed command signal, and an excitation execution unit configured to input the synthesized signal to the servo system.

FIG. 4

MEASUREMENT DEVICE 10

GENERATION UNIT 11

SYNTHESIZING UNIT 12

EXCITATION EXECUTION UNIT 13

ANALYSIS UNIT 14

EP 4 703 745 A1

**Description**

TECHNICAL FIELD

The present invention relates to a measurement assistance device.

BACKGROUND ART

A technique for analyzing frequency characteristics of a servo system has been proposed. For example, Patent Document 1 proposes a technique for analyzing frequency characteristics by inputting a position command that changes with time so as to include a large number of frequency components to a motor control device (see Patent Documents 1 and 2).

CITATION LIST

PATENT LITERATURE

Patent Document 1: JP 2020-030557 A
Patent Document 2: JP 2020-030558 A

SUMMARY OF INVENTION

Since the position control by the position command is equivalent to a control in which a low-pass filter is applied to the speed control, in a case where the frequency characteristics are analyzed by the position command, analysis accuracy in a high frequency band is lower than that in a case where the frequency characteristics are analyzed by the speed command. Furthermore, when the frequency response analysis is performed by the speed command, the position of the load at the time of start of the frequency response analysis and the position of the load at the time of completion of the frequency response analysis are shifted from each other. When such shifts in position are integrated, for example, there is a possibility that the load may move out of the movement range.
An object of one aspect of the disclosed technique is to provide a measurement assistance device capable of suppressing a positional shift of a load in frequency response analysis performed by inputting a speed command to a servo system.
One aspect of the disclosed technique is exemplified by the following measurement assistance device. The present measurement assistance device is a measurement assistance device that inputs a measurement signal used for a frequency response analysis of a servo system to the servo system, the measurement assistance device including: a generation unit configured to generate a first signal determined to eliminate a shift between a first position of a load of the servo system at a start of an input with respect to the servo system of a speed command signal that changes with time to include a large number of frequency components and a second position of the load at an end of the input of the speed command signal; a synthesizing unit configured to generate a synthesized signal in which the first signal is superimposed on the speed command signal; and an execution unit configured to input the synthesized signal to the servo system.
When a speed command signal that changes with time so as to include a large number of frequency components is input to the servo system, a shift may occur between the first position and the second position. In the present measurement assistance device, the first signal determined to eliminate such a shift is superimposed on the speed command signal to generate a synthesized signal. Then, the present measurement assistance device inputs the synthesized signal to the servo system. Since the synthesized signal is a signal on which the first signal is superimposed, the present measurement assistance device can suppress the positional shift of the load in the frequency response analysis performed by inputting the speed command to the servo system. Here, the speed command signal may be a Sweptsine.
Furthermore, the first signal may be expressed by Equation (6) satisfying Equation (7) below, where a is an arbitrary odd number, $V_{Lmax}$ is an amplitude of the speed command signal, t is time, $T_{inv}$ is time for inputting the speed command to the servo system, and L is a difference between the first position and the second position.

$$V_{Lmax} \sin \frac{a\pi}{T_{inv}} t \quad \cdot \ \cdot \ \cdot \text{ EQUATION (6)}$$

$$V_{Lmax} \int_0^{T_{inv}} \sin \frac{a\pi}{T_{inv}} t \, dt = L \quad \cdot \quad \cdot \quad \cdot \text{ EQUATION (7)}$$

The present measurement assistance device may further include the following features. An analysis unit configured to perform the frequency response analysis by using, as inputs, the speed signal fed back from the servo system to which the synthesized signal is input and the synthesized signal, and calculate frequency response characteristics of the servo system is further provided. The frequency response analysis may be an FFT analysis, and the FFT analysis may include a division type FFT analysis. According to the present measurement assistance device, the frequency response analysis of the servo system can be performed while suppressing the positional shift of the load.

According to the disclosed technique, the positional shift of the load in the frequency response analysis by the speed command can be suppressed.

BRIEF DESCRIPTION OF DRAWINGS

FIG. 1 is a diagram illustrating a schematic configuration of a system including a servo system whose frequency response is measured by a measurement device.
FIG. 2 is a diagram for explaining the servo system.
FIG. 3 is a diagram illustrating a vibration signal of a Sweptsine.
FIG. 4 is a functional block diagram illustrating various functions executed by software to be executed in the measurement device in an image form.
FIG. 5 is a diagram illustrating an example of a low-frequency sine wave generated by a generation unit.
FIG. 6 is a diagram illustrating an example of a composite wave generated by a synthesizing unit.
FIG. 7 is a diagram for comparing a case where a composite wave generated by the synthesizing unit is input to the servo system and a case where the vibration signal of the Sweptsine is input to the servo system.
FIG. 8 is a diagram illustrating an example of a response signal acquired by an analysis unit from a servo system to which the composite wave is input.
FIG. 9 illustrates frequency response characteristics in a case where the FFT is executed as a frequency response analysis by an analysis unit.
FIG. 10 illustrates frequency response characteristics in a case where a division type FFT is executed as the frequency response analysis by the analysis unit.
FIG. 11 is a diagram illustrating an example of a processing flow of the measurement device according to the embodiment.

DESCRIPTION OF EMBODIMENTS

<Application Example>

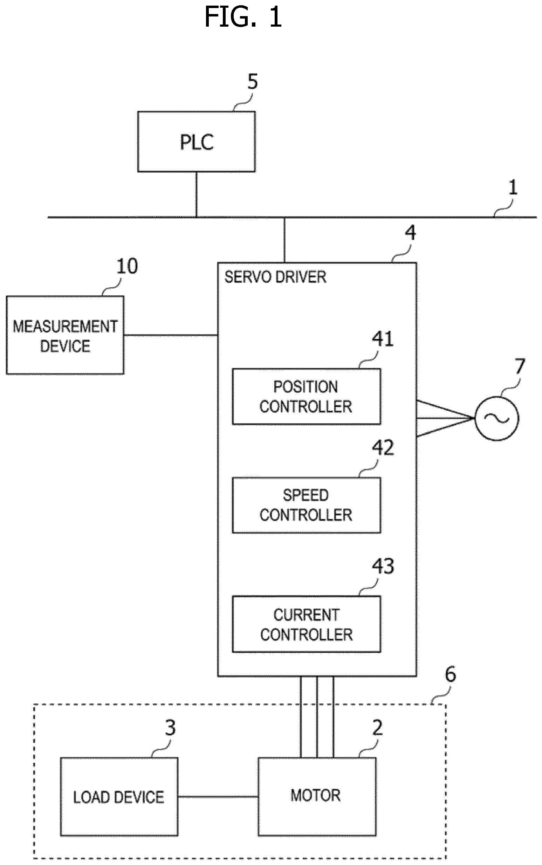

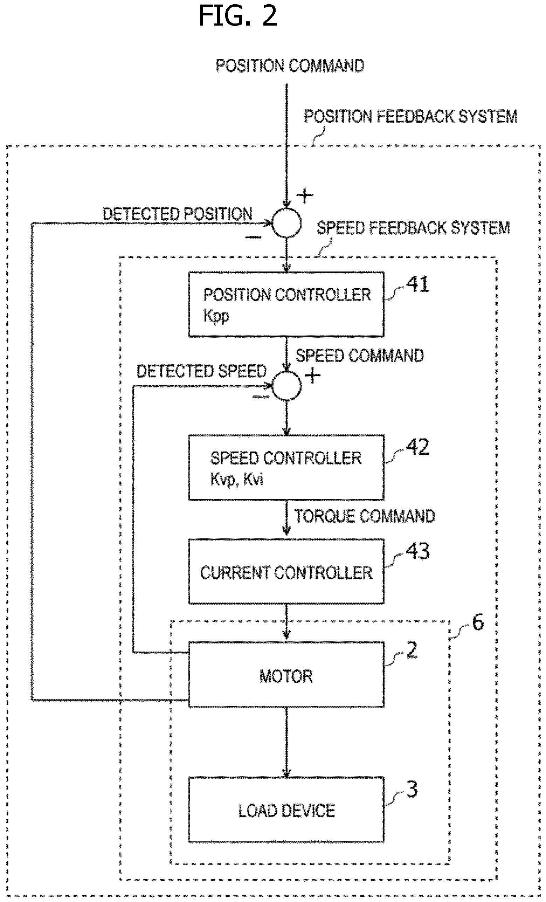

An application example of the present invention will be described. The application example of the present invention is, for example, a measurement device 10 illustrated in FIG. 1. The measurement device 10 is used for frequency response analysis of the servo system illustrated in FIG. 2. When a speed command is used in the frequency response analysis, the position of a load device 3 at the start and at the end of input of the speed command may be shifted from each other. When such shifts are integrated, there is a possibility that the load device 3 may move out of the movement range of the load device 3.

Therefore, the measurement device 10 generates a first signal determined to eliminate the shift in the position of the load device 3 with respect to the speed command input to the servo system. Then, the measurement device 10 generates a synthesized signal in which the first signal is superimposed on the speed command, and inputs the synthesized signal to the servo system. The positional shift of the load device 3 in the frequency response analysis by the speed command can be suppressed by inputting such a synthesized signal to the servo system.

<Embodiments>

Embodiments will be further described with reference to the drawings. FIG. 1 is a diagram illustrating a schematic configuration of a system including a servo system whose frequency response is measured by a measurement device 10. The control system includes a network 1, a motor 2, a load device 3, a servo driver 4, and a programmable logic controller (PLC) 5. The control system is a system for drive controlling the load device 3 together with the motor 2. The motor 2 and the load device 3 are control targets 6 to be controlled by the control system. Various mechanical devices (e.g., arms of industrial robots or conveyance devices) can be exemplified as the load device 3, and the motor 2 is incorporated in the load device 3 as an actuator that drives the load device 3. For example, the motor 2 is an AC servomotor. Note that an encoder (not illustrated) is attached to the motor 2, and a parameter signal related to the operation of the motor 2 is feedback transmitted to a servo driver 4 by the encoder. The parameter signal (hereinafter, referred to as a feedback signal) to be feedback transmitted includes, for example, position information on the rotational position (angle) of a rotation shaft of the motor 2, information on the rotational speed of the rotation shaft, and the like.

The servo driver 4 receives an operation command signal related to the operation (motion) of the motor 2 from the PLC 5 via the network 1, and receives a feedback signal output from an encoder connected to the motor 2. The servo driver 4 performs a servo control related to the driving of the motor 2, that is, calculates a command value related to the operation of the motor 2, based on the operation command signal from the PLC 5 and the feedback signal from the encoder, and supplies a drive current to the motor 2 so that the operation of the motor 2 follows a command value. Note that as the supply current, AC power transmitted from an AC power supply 7 to the servo driver 4 is used. In the present example, the servo driver 4 is a type that receives three-phase alternating current, but may be a type that receives single-phase alternating current. Note that in the servo driver 4, a servo system (see FIG. 2) is formed that performs a feedback control using a position controller 41, a speed controller 42, and a current controller 43 included in the servo driver 4.

FIG. 2 is a diagram for explaining the servo system. As illustrated in FIG. 2, the servo driver 4 includes a position controller 41, a speed controller 42, and a current controller 43. Here, a servo system in the servo driver 4 will be described with reference to FIG. 2. The position controller 41 performs, for example, proportional control (P control). Specifically, the speed command is calculated by multiplying the position shift, which is the shift between the position command and the detected position notified from the PLC 5, by a position proportional gain Kpp. Note that the position controller 41 has the position proportional gain Kpp as a control parameter in advance.

Next, the speed controller 42 performs, for example, proportional-integral control (PI control). Specifically, the torque command is calculated by multiplying the integral amount of the speed shift, which is the shift between the speed command and the detected speed calculated by the position controller 41, by a speed integration gain Kvi, and multiplying the sum of the calculation result and the speed shift by a speed proportional gain Kvp. Note that the speed controller 42 has the speed integration gain Kvi and the speed proportional gain Kvp as control parameters in advance. Furthermore, the speed controller 42 may perform P control instead of the PI control. In this case, the speed controller 42 has the speed proportional gain Kvp as the control parameter in advance. Next, the current controller 43 outputs a current command based on the torque command calculated by the speed controller 42, thereby drive controlling the motor 2. The current controller 43 includes a filter (primary low-pass filter) related to a torque command and one or a plurality of notch filters, and has a cutoff frequency, a center frequency, and the like related to the performance of these filters as control parameters.

The control structure of the servo driver 4 includes a speed feedback system in which the speed controller 42, the current controller 43, and the control target 6 are set as forward elements, and further includes a position feedback system in which the speed feedback system and the position controller 41 are set as forward elements. With the control structure configured as described above, the servo driver 4 can servo control the motor 2 to follow the position command supplied from the PLC 5.

Returning to FIG. 1, the measurement device 10 is electrically connected to the servo driver 4. The electrical connection may be a wired connection or a wireless connection. In order to set and adjust the control parameters of the servo driver 4, the measurement device 10 is loaded with software (program) for measuring the frequency response of the servo system. Specifically, the measurement device 10 is a computer including an arithmetic device, a memory, and the like, and executable measurement software is installed therein. Then, the measurement device 10 measures the frequency response of the servo system by using the measurement software.

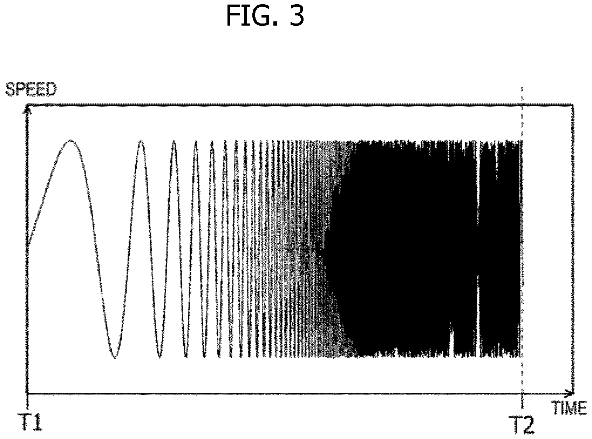

Here, a problem in measuring the frequency response of the servo system will be described. In the measurement of the frequency response, for example, a speed command in which the speed fluctuates with time is used. As such a speed command, for example, a vibration signal of the Sweptsine is used. FIG. 3 is a diagram illustrating a vibration signal of a Sweptsine. The vertical axis in FIG. 3 indicates speed, and the horizontal axis indicates time. In addition, in the vibration signal of the Sweptsine illustrated in FIG. 3, a period from time T1 to time T2 is assumed as a period in which the vibration signal is input to the servo system. Hereinafter, in the present specification, inputting a signal to the servo system is also referred to as "excitation".

The vibration signal of the Sweptsine is, for example, a speed command signal as illustrated in FIG. 3. When such a vibration signal is used to measure the frequency response, a shift may occur in the position of the load device 3 at the start of excitation and at the completion of excitation. For example, in the gain automatic adjustment, since excitation is automatically performed a plurality of times for the purpose of improving the identification accuracy of the device characteristics, such a positional shift is integrated. As a result of the integration of the positional shift, for example, it is conceivable that the load device 3 moves out of the movement range.

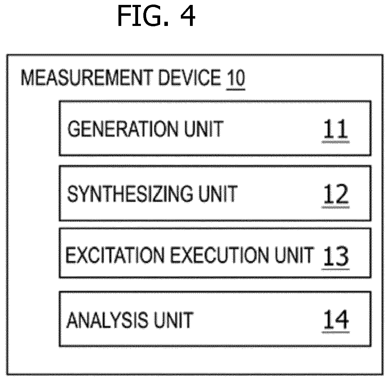

Therefore, in the present embodiment, the following configuration is adopted to suppress such a positional shift of the load device 3 at the start of excitation and at the completion of excitation. FIG. 4 is a functional block diagram illustrating various functions executed by software to be executed in the measurement device 10 in an image form. The measurement device 10 includes a generation unit 11, a synthesizing unit 12, an excitation execution unit 13, and an analysis unit 14.

The generation unit 11 generates a low-frequency sine wave to be superimposed on the vibration signal of the Sweptsine. The vibration signal of the Sweptsine is, for example, stored in the storage unit of the measurement device 10 in advance. The low-frequency sine wave is determined so as to suppress the positional shift of the load device 3 due to the vibration signal of the Sweptsine by being superimposed on the vibration signal. The low-frequency sine wave is defined by, for example, Equation (1) below. In Equation (1), $V_{Lmax}$ is an amplitude, $\omega_L$ is an angular frequency, and t is time.

$$V_{Lmax} \sin \omega_L t \quad \cdot \cdot \cdot \text{ EQUATION (1)}$$

The movement amount of the load device 3 by the low-frequency sine wave can be expressed by Equation (2) below, where L is the positional shift (position offset) of the load device 3 caused by the vibration signal before the low-frequency sine wave is superimposed, and $T_{inv}$ is the excitation time for exciting the vibration signal.

$$V_{Lmax} \int_0^{T_{inv}} \sin(\omega_L t)dt \; = \frac{V_{Lmax}}{\omega_L}\{1 - \cos(\omega_L T_{inv})\}$$

$$= L \quad \cdot \cdot \cdot \text{ EQUATION (2)}$$

Here, for simplicity, a waveform to be moved only in one direction opposite to the position offset is assumed as the low-frequency sine wave. In addition, it is assumed that the low-frequency sine wave superimposed on the vibration signal is a half cycle. In the low-frequency sine wave assumed in this way, a half cycle is the excitation time $T_{inv}$, and thus the angular frequency $\omega_L$ can be expressed by Equation (3) below.

$$\omega_L = \frac{\pi}{T_{inv}} \quad \cdot \cdot \cdot \text{ EQUATION (3)}$$

When Equation (3) is substituted into Equation (2) and rearranged, the amplitude $V_{Lmax}$ is derived by Equation (4) below.

$$V_{Lmax} = \frac{\pi L}{2T_{inv}} \quad \cdot \cdot \cdot \text{ EQUATION (4)}$$

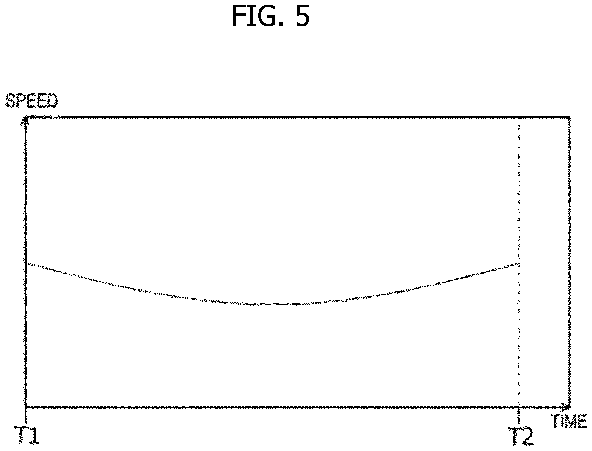

When Equations (2) and (3) are substituted into Equation (1), the obtained low-frequency sine wave can be expressed by Equation (5) below. The generation unit 11 generates the low-frequency sine wave determined in this manner. FIG. 5 is a diagram illustrating an example of a low-frequency sine wave generated by the generation unit 11. The vertical axis in FIG. 5 indicates speed, and the horizontal axis indicates time. The low-frequency sine wave expressed by Equation (5) is, for example, a speed command signal as illustrated in FIG. 5. In the speed command signal illustrated in FIG. 5, similarly to the vibration signal of the Sweptsine illustrated in FIG. 3, the period from time T1 to time T2 is a period in which excitation is applied to the servo system.

$$\frac{\pi L}{2T_{inv}} \sin(\frac{\pi}{T_{inv}} t) \quad \cdot \cdot \cdot \text{ EQUATION (5)}$$

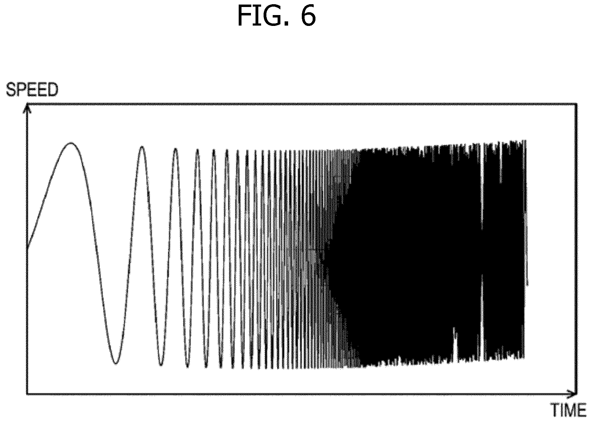

Returning to FIG. 4, the synthesizing unit 12 generates a composite wave by superimposing the low-frequency sine wave generated by the generation unit 11 on the vibration signal of the Sweptsine. FIG. 6 is a diagram illustrating an example of a composite wave generated by the synthesizing unit 12. The composite wave illustrated in FIG. 6 is generated when the low-frequency sine wave illustrated in FIG. 5 is superimposed on the vibration signal of the Sweptsine illustrated in FIG. 3. The composite wave is an example of a "synthesized signal".

The excitation execution unit 13 inputs, to the servo system, a composite wave in which the vibration signal of the Sweptsine and the low-frequency sine wave are superimposed by the synthesizing unit 12. The composite wave is obtained by superimposing a low-frequency sine wave determined so as to suppress the positional shift of the load device 3 due to the vibration signal of the Sweptsine. Therefore, since the composite wave is input to the servo system, the positional shift of the load device 3 is suppressed as compared with the case where the vibration signal of the Sweptsine is directly input to the servo system.

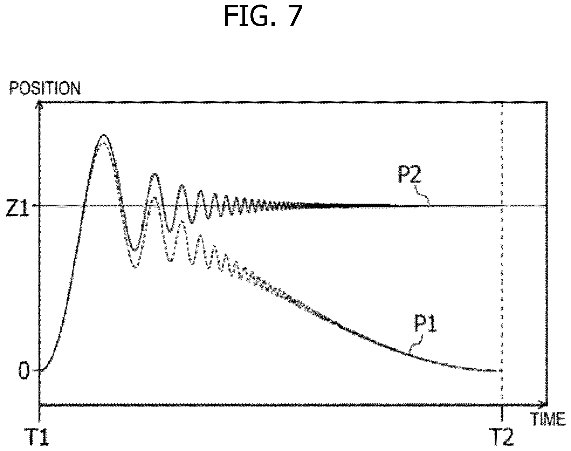

FIG. 7 is a diagram for comparing a case where the composite wave generated by the synthesizing unit 12 is input to the servo system and a case where the vibration signal of the Sweptsine is input to the servo system. A waveform P1 illustrates a fluctuation in the position of the load device 3 when the composite wave is input to the servo system. Furthermore, a waveform P2 illustrates a fluctuation in the position of the load device 3 when the vibration signal of the Sweptsine is input to the servo system. In the example of FIG. 7, it is assumed that the excitation is performed in a state where the start position of the load device 3 is a position "0" in both the waveform P1 and the waveform P2.

As can be understood with reference to FIG. 7, in the waveform P2, the position of the load device 3 at time T2 when the excitation ends is a position "Z1" different from the position "0". On the other hand, in the waveform P1, the position of the load device 3 at time T2 when the excitation ends returns to the position "0". This is because, in the waveform P1, the low-frequency sine wave is superimposed on the vibration signal of the Sweptsine, whereby the positional shift of the load device 3 due to the vibration signal of the Sweptsine is suppressed.

Returning to FIG. 4, the analysis unit 14 receives a response signal (speed signal) indicating the moving speed of the load device 3 as feedback for the composite wave input by the excitation execution unit 13. The analysis unit 14 performs a frequency response analysis using a combination of the composite wave input by the excitation execution unit 13 and the received response signal as an input. In the frequency response analysis by the analysis unit 14, for example, fast Fourier transform (FFT) may be performed, or division type FFT may be performed.

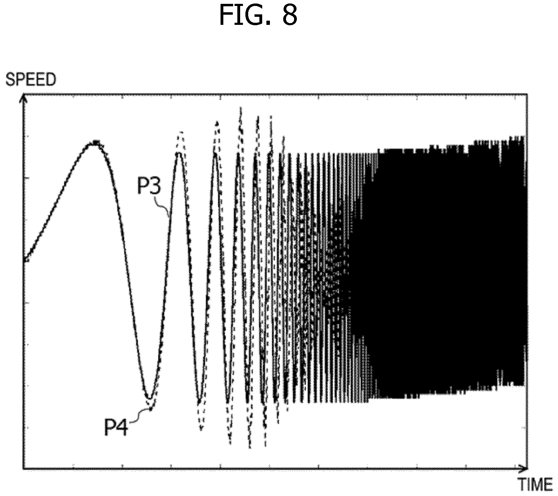

FIG. 8 is a diagram illustrating an example of a response signal acquired by the analysis unit 14 from the servo system to which the composite wave is input. The vertical axis in FIG. 8 indicates speed, and the horizontal axis indicates time. In FIG. 8, a waveform P3 illustrated by a solid line illustrates a composite wave, and a waveform P4 illustrated by a dotted line illustrates a response signal indicating an actually measured speed of the load device 3 in the servo system to which the composite wave is input. The analysis unit 14 performs a frequency response analysis based on the composite wave illustrated by the waveform P3 and the response signal illustrated by the waveform P4.

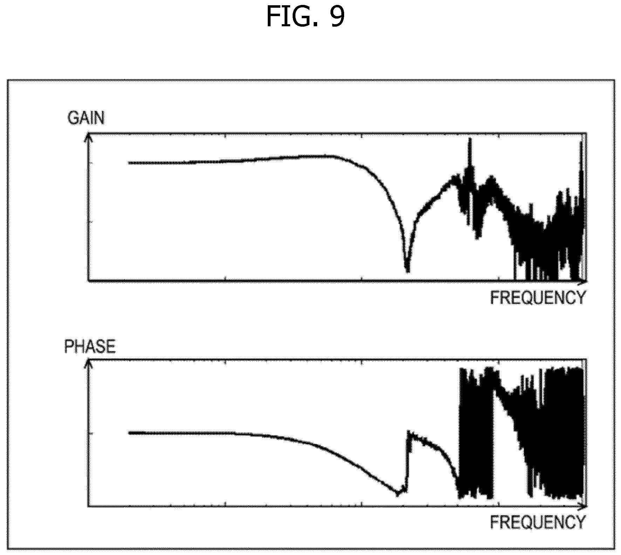

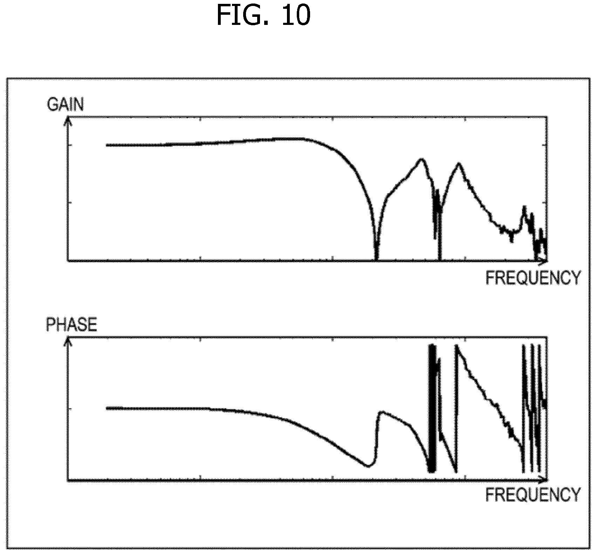

FIG. 9 illustrates frequency response characteristics in a case where the FFT is executed as the frequency response analysis by the analysis unit 14. In an upper part of FIG. 9, correspondence between a gain and a frequency is illustrated. In a lower part of FIG. 9, correspondence between a phase and a frequency is illustrated. Furthermore, FIG. 10 illustrates frequency response characteristics in a case where the division type FFT is executed as the frequency response analysis by the analysis unit 14. In an upper part of FIG. 10, correspondence between a gain and a frequency is illustrated. In a lower part of FIG. 10, correspondence between a phase and a frequency is illustrated. In this manner, the frequency response analysis is performed by the analysis unit 14, whereby the correspondence between the gain and the frequency and the correspondence between the phase and the frequency are analyzed. For example, the analysis unit 14 may output the result of the frequency response analysis to an output device such as a display connected to the measurement device 10.

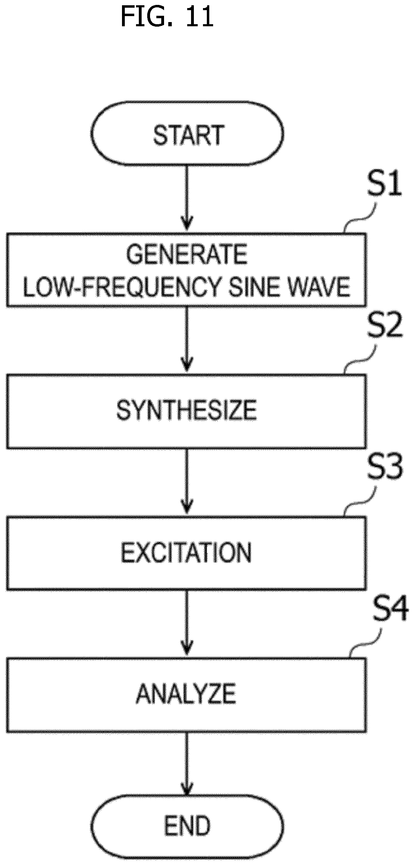

FIG. 11 is a diagram illustrating an example of a processing flow of the measurement device 10 according to the embodiment. Hereinafter, an example of a processing flow of the measurement device 10 will be described with reference to FIG. 11.

In step S1, the generation unit 11 generates a low-frequency sine wave that suppresses a positional shift of the load device 3 due to the vibration signal of the Sweptsine. In step S2, the synthesizing unit 12 synthesizes the low-frequency sine wave generated in step S1 and the vibration signal of the Sweptsine stored in advance in the storage unit of the measurement device 10 to generate a composite wave.

In step S3, the excitation execution unit 13 excites the composite wave generated in step S2 to the servo system. In step S4, the analysis unit 14 performs a frequency response analysis using, as an input, a combination of the composite wave input to the servo system in step S3 and the response signal received as feedback from the servo system.

<Advantageous Effects of Embodiments>

In the present embodiment, the low-frequency sine wave is determined so as to eliminate the positional shift of the load device 3 in a case where the vibration signal of the Sweptsine is input to the servo system. Then, in the present embodiment, a composite wave in which the low-frequency sine wave thus determined is superimposed on the vibration signal of the Sweptsine is input to the servo system. Therefore, according to the present embodiment, as described with reference to FIG. 7, the positional shift of the load device 3 is suppressed. Therefore, according to the present embodiment, the positional shift of the load device 3 in the frequency response analysis performed by inputting the speed command to the servo system is suppressed.

Here, the positional shift of the load device 3 is suppressed by performing the frequency response analysis using the position command, but since the position control by the position command is equivalent to the control in which the low-pass filter is applied to the speed control, the analysis accuracy in the high frequency band becomes lower in the frequency response analysis using the position command. In the present embodiment, since the composite wave input to the servo system is a speed command, such a lowering in analysis accuracy is suppressed. In addition, since the low-frequency excitation signal (low-frequency sine wave) is superimposed on the vibration signal of the Sweptsine, the S/N ratio of the frequency is improved and the analysis accuracy is improved.

Furthermore, in the present embodiment, the frequency response analysis is performed by the analysis unit 14 based on the response signal received from the servo system to which the composite wave is input and the composite wave input to the servo system. As the frequency response analysis, for example, the FFT or the division type FFT is adopted. For example, by adopting the division type FFT, the analysis accuracy near the resonance frequency is improved. Therefore, according to the present embodiment, the frequency response analysis of the servo system can be performed while suppressing the positional shift of the load device 3.

<Modified Example>

In the embodiment described above, the low-frequency sine wave represented by Equation (5) is superimposed on the vibration signal of the Sweptsine, but the low-frequency sine wave to be superimposed by the vibration signal of the Sweptsine is not limited to the waveform expressed by Equation (5). The low-frequency sine wave to be superimposed by the vibration signal of the Sweptsine may be any wave as long as it suppresses the positional shift (position offset L) of the load device 3 caused by the excitation of the vibration signal of the Sweptsine. Such a low-frequency sine wave may be expressed by, for example, Equation (6) satisfying Equation (7) below with a as an arbitrary odd number.

$$V_{Lmax} \sin \frac{a\pi}{T_{inv}} t \quad \cdot \cdot \cdot \text{EQUATION (6)}$$

$$V_{Lmax} \int_0^{T_{inv}} \sin \frac{a\pi}{T_{inv}} t \, dt = L \quad \cdot \cdot \cdot \text{EQUATION (7)}$$

In the embodiment described above, the measurement device 10 inputs the composite wave to the servo system and performs the frequency response analysis of the servo system, but the measurement device 10 may input the composite wave to the servo system, and a device different from the measurement device 10 may perform the frequency response analysis based on the response signal from the servo system and the composite wave. In such a case, the measurement device 10 may input a signal equivalent to the composite wave to the other device.

The embodiments and modified examples disclosed above can be combined.

<Supplementary Note 1>

A measurement assistance device that inputs a measurement signal used for a frequency response analysis of a servo system to the servo system, the measurement assistance device including:

a generation unit configured to generate a first signal determined to eliminate a shift between a first position of a load of the servo system at a start of an excitation with respect to the servo system of a speed command signal that changes with time to include a large number of frequency components and a second position of the load at an end of the excitation of the speed command signal;

a synthesizing unit configured to generate a synthesized signal in which the first signal is superimposed on the speed command signal; and

an excitation execution unit configured to input the synthesized signal to the servo system.

<Supplementary Note 2>

The measurement assistance device according to supplementary note 1, in which the speed command signal is a Sweptsine.

<Supplementary Note 3>

The measurement assistance device according to supplementary note 1 or 2, in which the first signal is expressed by Equation (6) satisfying Equation (7) below

$$V_{Lmax} \sin \frac{a\pi}{T_{inv}} t \quad \cdot \ \cdot \ \cdot \ \text{EQUATION (6)}$$

$$V_{Lmax} \int_0^{T_{inv}} \sin \frac{a\pi}{T_{inv}} t \, dt = L \quad \cdot \ \cdot \ \cdot \ \text{EQUATION (7)}$$

where a is an arbitrary odd number, $V_{Lmax}$ is an amplitude of the speed command signal, t is time, $T_{inv}$ is time for inputting the speed command to the servo system, and L is a difference between the first position and the second position.

<Supplementary Note 4>

The measurement assistance device according to any one of supplementary notes 1 to 3, further including: an analysis unit configured to perform the frequency response analysis by using, as inputs, the speed signal fed back from the servo system to which the synthesized signal is input and the synthesized signal, and calculate frequency response characteristics of the servo system.

<Supplementary Note 5>

The measurement assistance device according to supplementary note 4, in which the analysis unit executes an FFT analysis as the frequency response analysis.

<Supplementary Note 6>

The measurement assistance device according to supplementary note 5, in which the FFT analysis executed by the analysis unit includes a division type FFT analysis.

**Claims**

1. A measurement assistance device (10) that inputs a measurement signal used for a frequency response analysis of a servo system to the servo system, the measurement assistance device (10) comprising:

   a generation unit (11) configured to generate a first signal determined to eliminate a shift between a first position of a load of the servo system at a start of an excitation with respect to the servo system of a speed command signal that changes with time to include a large number of frequency components and a second position of the load at an end of the excitation of the speed command signal;
   a synthesizing unit (12) configured to generate a synthesized signal in which the first signal is superimposed on the speed command signal; and
   an excitation execution unit (13) configured to input the synthesized signal to the servo system.

2. The measurement assistance device (10) according to claim 1, wherein the speed command signal is a Sweptsine.

3. The measurement assistance device (10) according to claim 1 or 2, wherein

   the first signal is expressed by Equation (6) satisfying Equation (7) below

$$V_{Lmax} \sin \frac{a\pi}{T_{inv}} t \quad \cdot \ \cdot \ \cdot \ \text{EQUATION (6)}$$

$$V_{Lmax} \int_0^{T_{inv}} \sin\frac{a\pi}{T_{inv}} t \, dt = L \quad \cdot \quad \cdot \quad \cdot \text{ EQUATION (7)}$$

where a is an arbitrary odd number, $V_{Lmax}$ is an amplitude of the speed command signal, t is time, $T_{inv}$ is time for inputting the speed command to the servo system, and L is a difference between the first position and the second position.

4. The measurement assistance device (10) according to any one of claims 1 to 3, further comprising: an analysis unit (14) configured to perform the frequency response analysis by using, as inputs, the speed signal fed back from the servo system to which the synthesized signal is input and the synthesized signal, and calculate frequency response characteristics of the servo system.

5. The measurement assistance device (10) according to claim 4, wherein the analysis unit (14) executes an FFT analysis as the frequency response analysis.

6. The measurement assistance device (10) according to claim 5, wherein the FFT analysis executed by the analysis unit (14) includes a division type FFT analysis.

# FIG. 1

# FIG. 2

POSITION COMMAND

POSITION FEEDBACK SYSTEM

DETECTED POSITION

SPEED FEEDBACK SYSTEM

POSITION CONTROLLER
Kpp — 41

DETECTED SPEED

SPEED COMMAND

SPEED CONTROLLER
Kvp, Kvi — 42

TORQUE COMMAND

CURRENT CONTROLLER — 43

6

MOTOR — 2

LOAD DEVICE — 3

FIG. 3

FIG. 4

MEASUREMENT DEVICE 10

| GENERATION UNIT | 11 |

| SYNTHESIZING UNIT | 12 |

| EXCITATION EXECUTION UNIT 13 |

| ANALYSIS UNIT | 14 |

FIG. 5

FIG. 6

# FIG. 7

# FIG. 8

# FIG. 9

# FIG. 10

# FIG. 11

```
        ┌─────────────┐
        │    START    │
        └──────┬──────┘
               │
               ▼                          S1
        ┌─────────────────────────┐
        │      GENERATE           │
        │ LOW-FREQUENCY SINE WAVE │
        └──────┬──────────────────┘
               │
               ▼                          S2
        ┌─────────────────────────┐
        │      SYNTHESIZE         │
        └──────┬──────────────────┘
               │
               ▼                          S3
        ┌─────────────────────────┐
        │      EXCITATION         │
        └──────┬──────────────────┘
               │
               ▼                          S4
        ┌─────────────────────────┐
        │       ANALYZE           │
        └──────┬──────────────────┘
               │
               ▼
        ┌─────────────┐
        │     END     │
        └─────────────┘
```

Europäisches
Patentamt

European
Patent Office

Office européen
des brevets

## EUROPEAN SEARCH REPORT

**Application Number**

EP 25 19 2791

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2016 004775 A1 (FANUC CORP [JP]) 27 October 2016 (2016-10-27) | 1,2 | INV. G01R31/28 G05B13/00 |
| Y | * paragraph [0028]; figure 3 * <br> * paragraph [0019] - paragraph [0020]; figure 1 * <br> ----- | 4-6 | |
| Y | US 2023/084056 A1 (EGI MAMORU [JP] ET AL) 16 March 2023 (2023-03-16) * paragraph [0049] * <br> ----- | 4-6 | |

**TECHNICAL FIELDS SEARCHED (IPC)**

G01R
G05B

The present search report has been drawn up for all claims

| Place of search | Date of completion of the search | Examiner |
|---|---|---|
| Munich | 18 December 2025 | Schürle, Patrick |

EPO FORM 1503 03.82 (P4C01)

## ANNEX TO THE EUROPEAN SEARCH REPORT
## ON EUROPEAN PATENT APPLICATION NO.

EP 25 19 2791

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2025

| Patent document cited in search report | Publication date | Patent family member(s) | | Publication date |
|---|---|---|---|---|
| DE 102016004775 A1 | 27-10-2016 | CN | 106066636 A | 02-11-2016 |
| | | DE | 102016004775 A1 | 27-10-2016 |
| | | JP | 6212068 B2 | 11-10-2017 |
| | | JP | 2016207021 A | 08-12-2016 |
| | | US | 2016313726 A1 | 27-10-2016 |
| US 2023084056 A1 | 16-03-2023 | CN | 115151802 A | 04-10-2022 |
| | | DE | 112020006880 T5 | 26-01-2023 |
| | | JP | 7404947 B2 | 26-12-2023 |
| | | JP | 2021143941 A | 24-09-2021 |
| | | US | 2023084056 A1 | 16-03-2023 |
| | | WO | 2021181787 A1 | 16-09-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020030557 A

- JP 2020030558 A